Europäisches Patentamt

European Patent Office

Office européen des brevets

(11) Veröffentlichungsnummer: **0 327 692**

**A1**

(12) **EUROPÄISCHE PATENTANMELDUNG**

(21) Anmeldenummer: 88119729.7

(22) Anmeldetag: 26.11.88

(51) Int. Cl.⁴: **H01H 1/00 , G01R 31/32**

(30) Priorität: 28.01.88 DE 3802497

(43) Veröffentlichungstag der Anmeldung:
16.08.89 Patentblatt 89/33

(84) Benannte Vertragsstaaten:
DE FR GB IT

(71) Anmelder: **Licentia Patent-Verwaltungs-GmbH**
**Theodor-Stern-Kai 1**
**D-6000 Frankfurt/Main 70(DE)**

(72) Erfinder: **Drücker, Uwe, Dr.-Ing.**
**Karl-Feldmann-Strasse 4**
**D-2350 Neumünster(DE)**
Erfinder: **Schwarz, Gerd, Dipl.-Ing.**
**Krusenhofer Weg 34a**
**D-2351 Wasbek(DE)**
Erfinder: **Kobel, Karsten, Dipl.-Ing.**
**Pechsteinstrasse 7**
**D-2350 Neumünster(DE)**

(74) Vertreter: **Lertes, Kurt, Dr. et al**
**Licentia Patent-Verwaltungs-GmbH**
**Theodor-Stern-Kai 1**
**D-6000 Frankfurt/M 70(DE)**

(54) **Benutzungsführungsanzeige für Leistungsschalter.**

(57) Bei bekannten Leistungsschaltern müssen Informationen über die Bedienung der Schalter und Wartungshinweise, die auf den jeweiligen Betriebszustand Bezug nehmen, sowie Schaltplaninformationen über den Anschluß der Leistungsschalter im Bedarfsfall beigelegten Druckschriften entnommen werden. Diese Druckschriften können verloren gehen oder werden verlegt und stehen auch nicht immer vor Ort zur Verfügung. Der Erfindung liegt die Aufgabe zugrunde, Leistungsschalter oder Schaltgerätekombinationen der vorangehend erwähnten Art mit einer am Gerät abrufbaren oder anzeigbaren Benutzungsführung auszustatten.

Die Ausgabeeinheiten (1, 3, 4, 5) enthalten einen Informationsspeicher (2) in dem Bedienungs- und Wartungshinweise sowie Schaltpläne resident gespeichert und abrufbar auf einem Display (3) darstellbar sind.

Leistungsschalter oder Schaltgerätekombination mit mikroprozessorunterstützten Ein- Ausgabeeinheiten für die Eingabe von Betriebsparametern und Anzeige von Betriebszuständen.

_Fig._

## "Benutzungsführungsanzeige für Leistungsschalter"

Die Erfindung betrifft Leistungsschalter oder Schaltgerätekombinationen mit mikroprozessorunterstützten Ein- Ausgabeeinheiten für die Eingabe von Betriebsparametern und Anzeige von Betriebszuständen gemäß dem Oberbegriff des Anspruchs 1.

Es sind Schaltgeräte mit Überwachungs- und Kontrolleinrichtungen bekannt, die vom Betriebszustand ermittelte Wartungshinweise zur Anzeige bringen. Der Informationsinhalt dieser Anzeigen ist auf Meldungen über den vorliegenden Betriebszustand beschränkt (DE 35 05 818 A1).

Dahingegen müssen Informationen über die Bedienung der Schalter und Wartungshinweise, die auf den jeweiligen Betriebszustand Bezug nehmen, sowie Schaltplaninformationen über den Anschluß der Leistungsschalter im Bedarfsfall beigelegten Druckschriften entnommen werden. Diese Druckschriften können verloren gehen oder werden verlegt und stehen auch nicht immer vor Ort zur Verfügung.

Der Erfindung liegt die Aufgabe zugrunde, Leistungsschalter oder Schaltgerätekombinationen der vorangehend erwähnten Art mit einer am Gerät abrufbaren oder anzeigbaren Benutzungsführung auszustatten. Diese Aufgabe wird durch die im Kennzeichen des Anspruchs 1 angegebenen Merkmale gelöst. Weiterbildungen sind in den Unteransprüchen gegeben.

Die Erfindung hat den Vorteil, daß die vorgenannten Informationen für das Bedienpersonal unverlierbar und unverwechselbar mit dem Gerät verbunden sind; sie sind dort verfügbar, wo sie gebraucht werden. Ein weiterer Vorteil besteht darin, daß die Informationen auf die tatsächliche Ausführung des auszuliefernden Gerätes abgestimmt werden können.

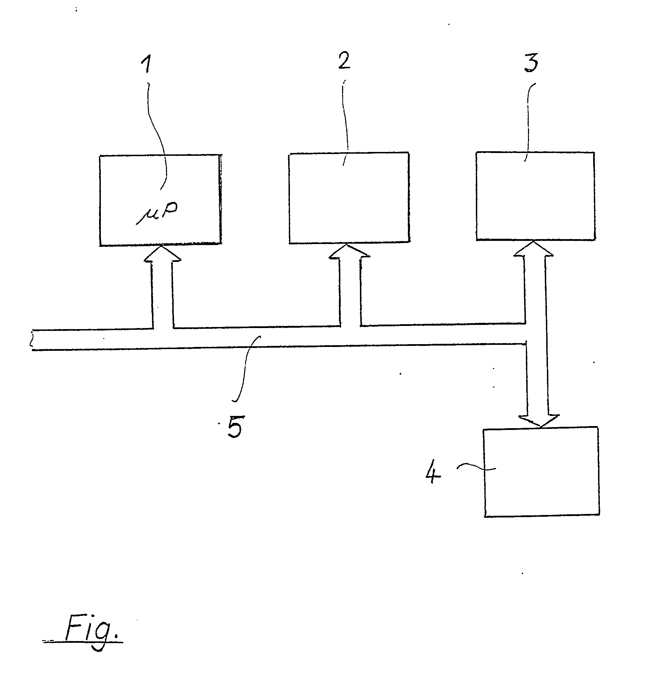

Anhand des in der Zeichnung dargestellten Blockdiagramms soll die Erfindung an einem Ausführungsbeispiel näher erläutert werden.

Die Figur zeigt schematisch die Einbindung des Informationsspeichers 2, der die Benutzungsführungsinformationen enthält, in die von einem Mikroprozessor 1 unterstützten Ausgabeeinheiten eines nicht dargestellten Leistungsschalters. Die Hinweise sind über ein Display 3 abrufbar oder über eine Datentransfer-Schnittstelle 4 extern auf einem Terminal darstellbar und veränderbar. Der interne Datenbus 5 verbindet den steuernden Mikroprozessor 1 mit dem Informationsspeicher 2 und den Ausgabeeinheiten 3 und 4. Als Speicher 2 für unverlierbare Informationen kann z.B. ein Halbleiterspeicher (ROM, EPROM, EEROM etc.) dienen.

## Ansprüche

1. Leistungsschalter oder Schaltgerätekombination mit mikroprozessorunterstützten Ein- Ausgabeeinheiten für die Eingabe von Betriebsparametern und Anzeige von Betriebszuständen, dadurch gekennzeichnet, daß die Ausgabeeinheiten (1, 3, 4, 5) einen Informationsspeicher (2) enthalten, in dem Bedienungs-und Wartungshinweise sowie Schaltpläne resident gespeichert und abrufbar auf einem Display (3) darstellbar sind.

2. Leistungsschalter oder Schaltgerätekombination gemäß Anspruch 1, dadurch gekennzeichnet, daß die residente Speicherung der Hinweise und Schaltpläne in einem Halbleiterspeicher (2) (ROM, EPROM, EEPROM etc.) durchgeführt wird.

3. Leistungsschalter oder Schaltgerätekombination gemäß Anspruch 1, dadurch gekennzeichnet, daß die Hinweise und Schaltpläne über ein Datentransfer-Interface (4) mit einem externen Terminal abgerufen, dargestellt und bei Bedarf verändert werden können.

4. Leistungsschalter oder Schaltgerätekombination gemäß Anspruch 1, dadurch gekennzeichnet, daß der Informationsspeicher (2) in dem Schutzauslösesystem des Leistungsschalters integriert ist.

5. Leistungsschalter oder Schaltgerätekombination gemäß Anspruch 4, dadurch gekennzeichnet, daß die Bedienungs- und Wartungshinweise des Informationsspeichers (2) auf dem Display des Schutzauslösesystems angezeigt werden.

*Fig.*

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-2 158 253 (FERRANTI)<br>* Zusammenfassung; Figur 1b *<br>--- | 1-4 | H 01 H    1/00<br>G 01 R   31/32 |
| A | EP-A-0 204 873 (CONTROL LOGIC)<br>--- | | |
| D,A | EP-A-0 193 732 (LICENTIA)<br>----- | | |

RECHERCHIERTE SACHGEBIETE (Int. Cl.4)

H 01 H
G 01 R

Der vorliegende Recherchenbericht wurde für alle Patentansprüche erstellt

| Recherchenort | Abschlußdatum der Recherche | Prüfer |
|---|---|---|
| DEN HAAG | 10-05-1989 | HOORNAERT W. |

EPO FORM 1503 03.82 (P0403)